# DEMANDE DE BREVET EUROPEEN

(11) **EP 2 512 034 A1**
(43) Date de publication de la demande: **17.10.2012**
(21) Numéro de dépôt: 12163967.8
(22) Date de dépôt: 12.04.2012
(51) Int. Cl.: H03M 1/18

(54) **Systeme de conversion analogique-numerique comprenant une double boucle de controle automatique de gain**

(30) Priorité: 14.04.2011 FR 1101162
(71) Demandeur: Thales, 92200 Neuilly Sur Seine (FR)
(72) Inventeur: Martin, Nicolas, 26500 Bourg Les Valence (FR); Perre, Jean-Michel, 07130 St Peray (FR); Depraz, David, 26000 Valence (FR)
(74) Mandataire: Brunelli, Gérald

(57) **Abrégé**

L'invention a pour objet un système de conversion analogique-numérique comprenant au moins un amplificateur à gain variable (400, 600) amplifiant un signal d'entrée e, un convertisseur analogique-numérique CAN (401, 601) numérisant ledit signal e, un module de traitement numérique anti-interférence (407, 602) du signal numérisé. Il comprend aussi une première boucle de contrôle automatique de gain CAG (402, 604) dite boucle CAG analogique comparant une estimation (403) de la puissance en sortie du convertisseur CAN (401, 601) avec une consigne de commande g1 appelée consigne de commande de la boucle CAG analogique, un gain ga utilisé pour contrôler l'amplificateur à gain variable (400, 600) étant déduit de cette comparaison. Il comprend en outre une seconde boucle de contrôle automatique de gain CAG (420, 605) dite boucle numérique, ladite boucle numérique comparant (423) une estimation (421) de la puissance après le traitement numérique anti-interférence (407, 602) avec une consigne de commande gn prédéterminée, la boucle CAG analogique (402, 604) étant contrôlée par une consigne de commande (402, 604, 804) déduite de cette comparaison.

## Description

L'invention concerne un système de conversion analogique-numérique comprenant une double boucle de contrôle automatique de gain et s'applique notamment au domaine des communications radio.

Dans un récepteur de radiocommunications numériques, la démodulation des signaux est réalisée en numérique. Avant d'effectuer cette démodulation, un étage analogique du récepteur ramène le signal autour d'une fréquence intermédiaire. Cet étage analogique a également pour objectif d'amplifier le signal et de le filtrer à l'aide d'un filtre anti-repliement. Après filtrage, le signal est numérisé en utilisant un convertisseur analogique-numérique désigné habituellement par l'acronyme CAN.

Dans les conditions de réception nominales sans interférences, la conversion analogique-numérique d'un signal analogique n'a besoin que d'un nombre de bits N réduit. Cela permet de limiter la complexité des traitements numériques réalisés sur le signal numérisé. Si on positionne la puissance du signal en entrée d'un convertisseur CAN au maximum du rendement de conversion R possible, la perte introduite par la numérisation est limitée. Pour N=3, la perte due à la numérisation ne dépasse pas 0.2 dB. Le rendement R de conversion est le ratio entre le rapport signal à bruit avant conversion et le rapport signal à bruit après conversion.

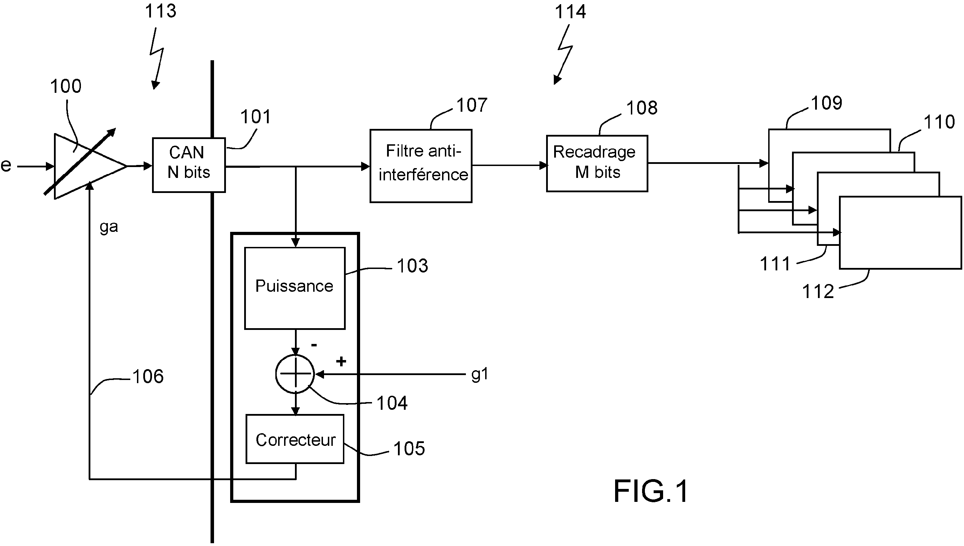

Afin d'asservir le gain de la chaîne analogique de façon à avoir un rendement maximal du convertisseur CAN, une boucle de contrôle adaptatif de gain CAG, appelée aussi boucle de contrôle automatique de gain, est habituellement utilisée. La figure 1 donne un exemple de chaîne de réception comprenant une boucle CAG. Cette chaîne de réception comprend un étage analogique 113 et un étage numérique 114. L'étage analogique comprend notamment un amplificateur à gain variable 100 ayant pour objectif l'amplification d'un signal analogique d'entrée e. Après amplification, le signal est introduit dans un convertisseur CAN 101 sur N bits. Le signal numérisé correspond à une succession d'échantillons numériques codés sur N bits. Il est filtré à l'aide d'un filtre numérique 107 anti-interférence, par exemple de type filtre à réponse impulsionnelle finie FIR. Les bits en sortie du filtre sont recadrés 108 c'est-à-dire codés sur un nombre de bit plus petit, l'opération de recadrage étant habituellement désignée par l'expression anglo-saxonne « bit rescaling ». Le signal ainsi numérisé, filtré et recadré est ensuite utilisé pour démoduler le ou les canaux de communications transmis 108, 109, 110, 111, 112. A titre d'exemple, les systèmes de radionavigation GNSS, acronyme venant de l'expression anglo-saxonne « Global Navigation Satellite System », utilisent habituellement des signaux large bande générés en utilisant la technique d'étalement de spectre. Dans ce cas, un canal de communication est associé à un code d'étalement.

Afin de contrôler l'amplitude du signal analogique en entrée du convertisseur CAN, la boucle CAG 102 comporte un module de détermination de la puissance 103 en sortie dudit convertisseur et/ou de la moyenne de cette puissance et la compare 104 à une consigne de commande g1. La différence entre la puissance mesurée et la consigne est utilisée par un correcteur 105 pour déterminer un gain analogique ga 106 à appliquer à l'amplificateur à gain variable 100 de l'étage analogique 113. Le correcteur consiste à appliquer un gain à ladite différence avant d'alimenter un intégrateur infini, jamais remis à zéro. Le choix de la consigne de commande g1 dépend de la valeur du rendement R optimal pour la conversion. Le choix du gain détermine la constante de temps de la boucle CAG.

Si des interférences affectent le signal d'entrée e, celles-ci doivent être prises en compte par l'étage numérique 114, mais aussi au moment de la conversion 101 analogique-numérique.

Comme explicité précédemment, le rôle de la boucle CAG est d'asservir le gain d'amplification introduit par l'étage analogique de manière à exploiter au mieux toute l'amplitude de codage du convertisseur CAN tout en évitant la saturation. Ainsi le rapport de la puissance du signal utile contenu dans le signal reçu sur la puissance du bruit de quantification est maximisé.

Le paramétrage de la boucle CAG peut être adapté de manière à prendre en compte le type d'interférences qui affecte le signal. Ainsi, la boucle CAG peut être paramétrée pour mettre en oeuvre un codage bas ou un codage haut. On distingue trois types d'interférences affectant un signal. Le premier type correspond aux interférences bande étroite continues, le deuxième type correspond aux interférences bande étroite pulsées et le troisième type correspond aux interférences large bande.

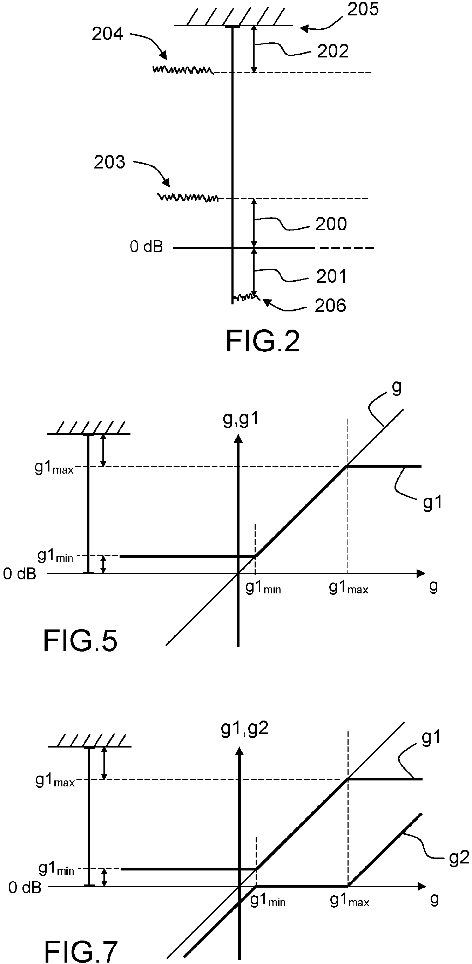

Les interférences bande étroite continues sont des interférences qui affectent de manière continue une portion de la bande occupée par le signal utile. Dans ce cas, un filtrage numérique coupe bande permet d'éliminer les fréquences polluées sans nuire irrémédiablement au signal utile occupant un spectre plus large. Le signal utile étant étalé sur une large bande, il reste assez de signal utile pour le démoduler. Pour que le filtrage numérique soit efficace en présence d'interférences, il faut numériser le signal reçu avec un grand nombre de bits, par exemple avec N>6. En effet le convertisseur CAN introduit un bruit de quantification qu'il faut minimiser car ce bruit est uniformément réparti dans toute la bande échantillonnée. Il ne peut donc pas être éliminé par filtrage numérique. Pour que le rapport de la puissance du signal utile sur la puissance du bruit de quantification soit maximal, il faut que la puissance du signal en entrée du convertisseur CAN occupe toute la dynamique dudit convertisseur sans pour autant saturer. Pour cela, la boucle CAG est paramétrée en utilisant un codage haut. La figure 2 illustre les manières dont le signal analogique d'entrée peut être adapté à la dynamique du convertisseur CAN.

La puissance du signal d'entrée ne doit pas dépasser une limite de saturation 205 propre au convertisseur. Un codage haut signifie qu'une consigne g1 de commande haute 204 est choisie afin que la puissance du signal en entrée du convertisseur soit la plus proche possible de la limite de saturation 205 tout en garantissant une marge de saturation 202. Tant que la puissance totale du signal reçu est continue, l'asservissement de la boucle CAG en codage haut assure une conversion optimale, sans saturation et avec un rapport puissance du signal sur bruit de quantification maximal.

Les interférences bande étroite pulsées sont des interférences intermittentes qui n'affectent qu'une portion de la bande occupée par le signal utile. Face à ce type d'interférences, la boucle CAG n'a pas le temps de réagir pour contrôler la dynamique du signal en entrée du convertisseur analogique numérique. Il y a saturation et la conséquence de cette saturation est que la puissance parasite est étalée dans toute la bande. Dans ce cas, le filtrage numérique devient inopérant et l'on retrouve un signal pollué en sortie. C'est pourquoi il est préférable dans ce cas d'utiliser un codage bas pour la boucle CAG. En d'autres termes, une consigne basse 203 de CAG est choisie afin de conserver une marge de saturation maximale pour les interférences pulsées. La puissance du signal d'entrée doit être suffisamment importante par rapport au bruit de quantification 206. Pour cela, le signal d'entrée est adapté en prenant en compte une marge de quantification 201 pour ne pas dégrader sensiblement le rapport signal à bruit après conversion numérique. Un codage bas signifie qu'une consigne g1 basse 203 est choisie afin que la puissance du signal en entrée du convertisseur soit la plus faible possible tout en garantissant une marge de quantification 201 suffisante. L'inconvénient du codage bas est qu'en présence d'interférences continues à bande étroite, le niveau du bruit de quantification remonte par rapport au niveau de signal utile.

En présence d'interférences bande étroite, les performances de réception dépendent donc du choix entre codage haut 204 et codage bas 203, c'est-à-dire du choix entre une consigne haute pour traiter au mieux les interférences à bande étroite continue et une consigne basse pour les interférences à bande étroite pulsées.

Les interférences large bande sont des interférences qui occupent toute la bande utile du signal. Un filtrage numérique coupe bande ne permet donc pas de faire le tri entre les fréquences polluées par ces interférences et celles qui ne le sont pas. Dans ce cas le choix d'un codage haut ou d'un codage bas n'as pas d'importance.

En outre, lorsqu'il y a trop d'interférences pulsées, la puissance moyenne en sortie du convertisseur CAN augmente. Cela a pour effet de diminuer le gain d'amplification ga de par la rétroaction 106 de la boucle CAG et donc de faire remonter le niveau du bruit de quantification par rapport au signal utile.

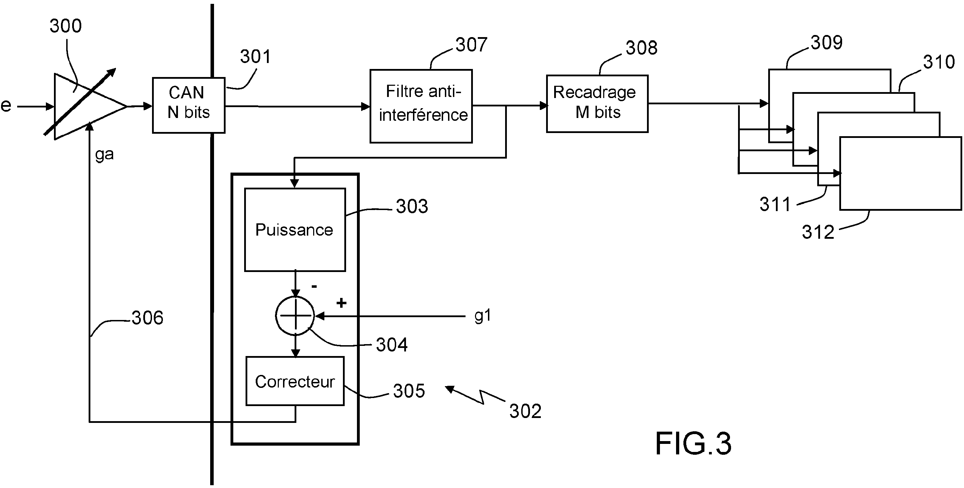

La figure 3 illustre une technique existante permettant d'éviter ce phénomène. La chaîne de transmission de la figure 3 comprend un étage analogique composé d'un amplificateur à gain variable 300 ayant pour objectif l'amplification d'un signal analogique d'entrée e. Après amplification, le signal est introduit dans un convertisseur CAN 301 sur N bits. Le signal numérisé est filtré à l'aide d'un filtre numérique 307 anti-interférence. Les bits en sortie du filtre sont recadrés 308 sur M bits. Le signal est ensuite utilisé pour démoduler le ou les canaux de communications reçus 308, 309, 310, 311, 312. Afin de contrôler la dynamique du signal analogique en entrée du convertisseur CAN 301, une boucle CAG 302 détermine 303 une puissance de signal, compare 304 cette puissance à une consigne de commande g1 et détermine une différence entre cette puissance et la consigne g1. Un correcteur 305 est ensuite utilisé pour déterminer le gain ga analogique à appliquer 306 à l'amplificateur à gain variable 300. A la différence de la chaîne de réception présentée sur la figure 1, la boucle CAG 302 se base sur le signal en sortie du filtre anti-interférence 307 débarrassé des interférences à bande étroite pour estimer 303 la puissance.

L'inconvénient de cette solution est qu'il n'y a aucun contrôle de la puissance en sortie du convertisseur CAN 301. Ainsi, en cas d'interférence bande étroite continue puissante, le convertisseur CAN 301 commence à saturer avant que la boucle CAG 302 ne réagisse. Après saturation l'interférence étalée dans la bande réapparaît en sortie du filtre anti-interférence, la boucle réagit trop tardivement. L'utilisation du signal sortie du filtre anti-interférence pour estimer la puissance utilisée dans la boucle CAG 302 permet d'asservir indirectement la puissance du signal hors interférence en entrée dudit filtre car la relation entre la puissance d'entrée et la puissance de sortie est connue dans le cas d'un bruit blanc. Néanmoins, cela ne permet pas de contrôler ce qui se passe en entrée du convertisseur CAN 301, en particulier les risques de saturation.

Un but de l'invention est notamment de pallier les inconvénients précités.

A cet effet l'invention a pour objet un système de conversion analogique-numérique comprenant au moins un amplificateur à gain variable amplifiant un signal d'entrée e, un convertisseur analogique-numérique CAN numérisant ledit signal e, un module de traitement numérique anti-interférence du signal numérisé. Il comprend aussi une première boucle de contrôle automatique de gain CAG dite boucle CAG analogique comparant une estimation de la puissance en sortie du convertisseur CAN avec une consigne de commande g1 appelée consigne de commande de la boucle CAG analogique, un gain ga utilisé pour contrôler l'amplificateur à gain variable étant déduit de cette comparaison. Il comprend en outre une seconde boucle de contrôle automatique de gain CAG dite boucle numérique, ladite boucle numérique comparant une estimation de la puissance après le traitement numérique anti-interférence avec une consigne de commande gn prédéterminée, la boucle CAG analogique étant contrôlée en utilisant le résultat de cette comparaison.

Selon un aspect de l'invention, la consigne de la boucle CAG analogique est déduite du résultat de la comparaison réalisée par la boucle CAG numérique entre l'estimation de la puissance en sortie du traitement numérique anti-interférence et la consigne de commande gn prédéterminée.

Le résultat de la comparaison réalisée par la boucle CAG numérique entre l'estimation de la puissance en sortie du traitement numérique anti-interférence et la consigne de commande gn prédéterminée est par exemple utilisé pour déterminer un gain, ce gain étant appliqué au signal en sortie du convertisseur CAN avant estimation de la puissance du signal.

Selon un autre aspect de l'invention, les estimations de puissance utilisées par les boucles CAG analogique et numériques sont des estimations de puissance moyenne.

La consigne commande de la boucle CAG analogique peut être déterminée par la boucle CAG numérique en utilisant un correcteur, ledit correcteur appliquant un gain au résultat de la comparaison et intégrant les échantillons de signal ainsi obtenus et dans lequel le gain ga est déterminé par la boucle CAG analogique en utilisant un correcteur, ledit correcteur appliquant un gain au résultat de la comparaison et intégrant les échantillons de signal ainsi obtenus.

Selon un aspect de l'invention, une constante de temps différente est utilisée pour les deux boucles CAG, la constante de temps de la boucle CAG analogique étant choisie de durée inférieure à la constante de temps de la boucle CAG numérique.

Un correcteur détermine par exemple une consigne g, un module de saturation adaptant cette consigne de manière à obtenir la consigne de commande de la boucle CAG analogique g1 adaptée de sorte que :

| | |
|---|---|
| si g ≥ gmax | alors g1 = g1 max |
| si g1 min < g < g1 max, | alors g1 = g |
| si g ≤ g1 min | alors g1 = g1 min |

expressions dans lesquelles :
g1 min correspond à la marge de quantification du convertisseur CAN;
g1 max correspond à la marge de saturation du convertisseur CAN.

A titre d'exemple, le module de saturation détermine une seconde consigne adaptée g2 à partir de la consigne g de manière à ce que g2 = g - g1, le gain g2 étant appliqué au signal en sortie du traitement numérique anti-interférence.

Par ailleurs, l'invention prévoit un module d'excision de pulse mise en oeuvre après le traitement numérique anti-interférence.

Selon une forme de réalisation avantageuse de l'invention, un module de non-linéarité est mis en oeuvre dans la boucle CAG analogique après comparaison, ce module ayant pour fonction de donner plus de poids au signal au moment où celui-ci n'est pas perturbé, c'est-à-dire lorsque la puissance estimée est plus faible.

Un module de non-linéarité est par exemple mis en oeuvre dans la boucle CAG numérique après comparaison, ce module ayant pour fonction de donner plus de poids au signal au moment où celui-ci n'est pas perturbé, c'est-à-dire lorsque la puissance estimée est plus faible.

Dans un mode de réalisation de l'invention, plusieurs signaux analogiques d'entrée e1, e2, e3 en provenance de plusieurs capteurs sont amplifiés et convertis en signaux numériques, un amplificateur à gain variable et un convertisseur CAN étant associé à un signal d'entrée. Ces signaux d'entrée après avoir été amplifiés et numérisés sont traités par un module de traitement numérique anti-interférence de sorte qu'un signal résultant d'une combinaison des signaux numérisés soit obtenu, une boucle CAG numérique étant utilisée pour déterminer une consigne de commande G1 utilisée par une pluralité de boucles CAG analogiques, une boucle CAG analogique étant utilisée par signal d'entrée.

Le traitement numérique anti-interférence est par exemple un filtre numérique à réponse impulsionnelle finie.

Alternativement, selon une variante de réalisation, le traitement numérique anti-interférence est un traitement d'amplitude ADP.

Alternativement, selon une variante de réalisation, le traitement numérique anti-interférence est un traitement spatial utilisant une antenne multi-capteurs ou un traitement spatio-temporel STAP.

Un module de recadrage est par exemple mis en oeuvre après le traitement numérique anti-interférences.

Le signal d'entrée est par exemple un signal large bande généré en utilisant la technique d'étalement de spectre.

D'autres caractéristiques et avantages de l'invention apparaîtront à l'aide de la description qui suit donnée à titre illustratif et non limitatif, faite en regard des dessins annexés parmi lesquels :
- la figure 1 donne un exemple de chaîne de réception comprenant une boucle CAG;
- la figure 2 illustre les manières dont un signal analogique d'entrée peut être adapté à la dynamique d'un convertisseur CAN;
- la figure 3 illustre une technique existante permettant d'éviter le phénomène de diminution du gain d'amplification en présence d'interférences pulsées;
- la figure 4 présente un premier mode de réalisation du système de conversion analogique-numérique selon l'invention;
- la figure 5 illustre le fonctionnement d'un module de saturation;
- la figure 6 présente un second mode de réalisation du système de conversion analogique-numérique selon l'invention;
- la figure 7 présente la manière dont les consignes de commandes de commande sont utilisées dans le second mode de réalisation;
- la figure 8 présente un troisième mode de réalisation du système de conversion analogique-numérique selon l'invention;
- la figure 9 donne un exemple de fonction non-linéaire pouvant être avantageusement mise en oeuvre par un module de non-linéarité ;
- la figure 10 présente un autre mode de réalisation de l'invention dans le cadre d'une architecture multi-capteurs.

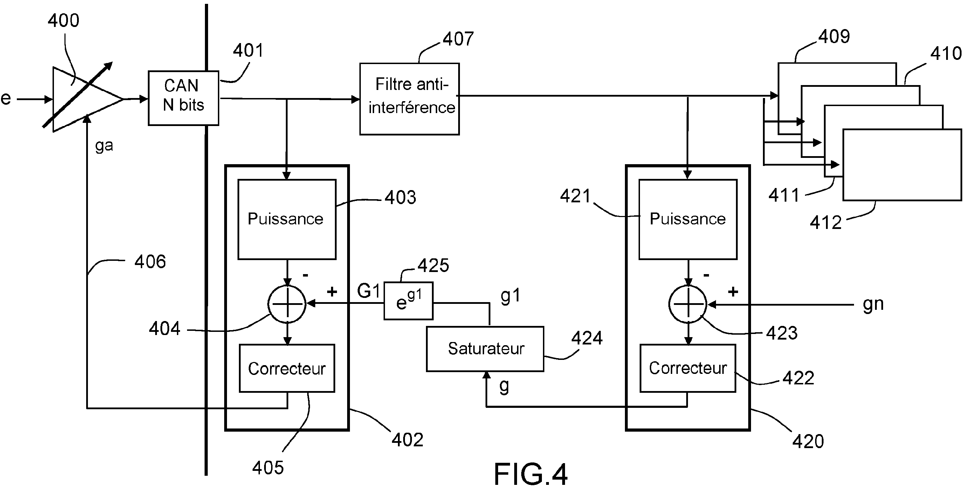

La figure 4 présente un premier mode de réalisation du système de conversion analogique-numérique selon l'invention. Le système est composé d'une chaîne de transmission comprenant un étage analogique lui même composé d'un amplificateur à gain variable 400. Cet amplificateur a pour objectif l'amplification d'un signal analogique d'entrée e. Après amplification, le signal est traité par un convertisseur CAN 401 sur N bits. Le signal numérisé en sortie du convertisseur 401 est filtré à l'aide d'un filtre numérique anti-interférence 407. Le signal est ensuite utilisé pour démoduler le ou les canaux de communications reçus 409, 410, 411, 412.

Le système de conversion analogique-numérique selon l'invention met en oeuvre deux boucles CAG en cascade 402, 420. La première boucle CAG 402 est une boucle CAG analogique classique se basant sur une estimation de puissance en sortie du convertisseur CAN 401. La seconde boucle CAG 420 est une boucle CAG dite numérique se basant sur une estimation de puissance en sortie du filtre anti-interférence 407 et dont l'objectif est de déterminer la consigne de commande de la première boucle.

Afin de contrôler la dynamique du signal analogique en entrée du convertisseur CAN 401, la première boucle CAG analogique 402 détermine 403 la puissance du signal en sortie du convertisseur CAN 401 ou une moyenne de cette puissance, et la compare 404 à une consigne de commande g1 correspondant à une valeur de puissance et détermine une différence de niveau de puissance utilisée par un correcteur 405 pour déterminer le gain analogique ga à appliquer 406 à l'amplificateur à gain variable 400.

La consigne de commande G1 de la boucle CAG analogique 402 est pilotée par la seconde boucle, c'est-à-dire la boucle CAG numérique 420 se basant sur le signal en sortie du filtre anti-interférences. Cette seconde boucle CAG 420 comprend des moyens 421 pour estimer la puissance du signal après filtrage anti-interférence 407 ou une moyenne de cette puissance, des moyens 423 pour comparer cette puissance à une consigne de puissance gn appelée consigne de commande numérique et un correcteur 422 dont la fonction est de générer une consigne g sur la base de ladite comparaison.

La consigne g peut être adaptée afin d'obtenir une consigne adaptée g1 en utilisant un module de saturation appelé aussi saturateur 424. Le fonctionnement de ce module peut être décrit à l'aide de la figure 5 et des expressions suivantes :

| | | |
|---|---|---|
| g ≥ gmax | ⇒ | g1 = g1 max |
| g1min < g < g1max, | ⇒ | g1 = g |
| g ≤ g1min | ⇒ | g1 = g1min |

g1 min correspond à la marge de quantification du convertisseur CAN et g1 max correspond à la marge de saturation du convertisseur CAN. A titre d'exemple, les valeurs de g1 min et de g1 max peuvent être choisies de la manière suivante :
g1min ≥ 0 dB
g1max ≥ 6 dB
g1 min < g1 max

Tant que la consigne g reste entre une limite minimale g1min équivalente au codage bas et une limite maximale g1max équivalente à un codage haut on a g1 = g. La consigne g1 est ensuite convertie 425 en une consigne de commande G1 = e^{g1} utilisée comme consigne de commande de la boucle CAG analogique 402. Le contrôle de la puissance en entrée du convertisseur CAN 401 est conservé grâce à la boucle CAG analogique 402 et aux limites g1min et g1max allouées à sa consigne de commande. Cela permet d'éviter la saturation du convertisseur CAN en cas d'interférences bande étroite trop puissantes et non visibles en sortie du filtre anti-interférence 407.

Afin d'assurer un comportement stable des deux boucles d'asservissement en cascade, une constante de temps différente peut être utilisée pour les deux boucles CAG en choisissant des gains de boucle appropriés lors de la conception des correcteurs 405, 422. Dans un mode de réalisation préféré, une constante de temps rapide est utilisée pour la boucle CAG analogique 402 alors qu'une constante plus lente est utilisée pour la boucle CAG numérique 420. Cela permet avantageusement d'améliorer la stabilité du système.

La boucle CAG numérique 420 positionne automatiquement la consigne G1 de la CAG analogique 402 de manière à ce que le gain analogique ga asservi sur la consigne donne une puissance du signal en sortie du filtre anti-interférence égale à la consigne de commande gn de la boucle CAG numérique.

Si la puissance du signal reçu par le système augmente, la boucle CAG analogique 402 réagit immédiatement pour compenser le gain analogique ga, et la CAG numérique 420 ne perçoit pas de changement.

Lorsqu'une interférence bande étroite apparaît, cela a pour effet d'augmenter la puissance totale en sortie du convertisseur CAN 401. La boucle CAG analogique 402 réagit à court terme en diminuant le gain analogique ga 406. Le signal en sortie du filtre anti-interférence 407, débarrassé de l'interférence bande étroite, voit sa puissance diminuer. En conséquence, la boucle CAG numérique 420 réagira à son tour en augmentant la consigne G1 de la boucle CAG analogique. Il apparaît donc que le gain analogique ga retrouvera sa valeur initiale. Seule la consigne G1 de la CAG analogique aura été modifiée.

Lorsque la valeur de la consigne g déterminée par la boucle numérique 420 atteint les limites g1 min et g1 max correspondant respectivement aux marges de saturation et de quantification, la consigne analogique adaptée g1 par le module de saturation 424 reste bloquée à l'une de ces valeurs limites g1 min ou g1max. Cela implique que la boucle CAG numérique 420 n'a plus d'effet et que la puissance en sortie du filtre anti-interférence n'est plus contrôlée. Avantageusement, les phénomènes de saturation et de dégradation du rapport signal sur bruit due au bruit de quantification sont évités.

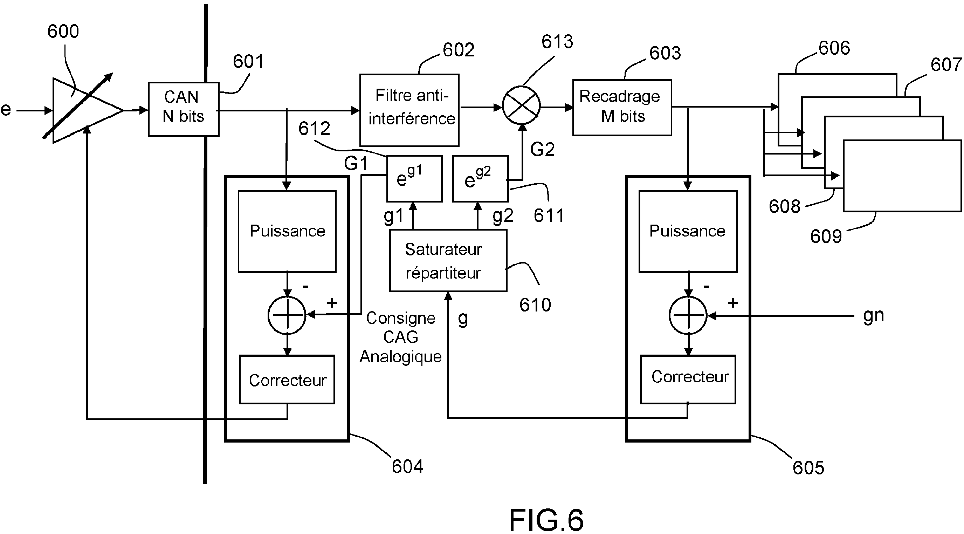

La figure 6 présente un second mode de réalisation du système de conversion analogique-numérique selon l'invention. Le système est composé d'une chaîne de transmission comprenant un étage analogique lui même composé d'au moins un amplificateur à gain variable 600. Cet amplificateur a pour objectif l'amplification d'un signal analogique e d'entrée. Après amplification, le signal est traité par un convertisseur CAN 601 sur N bits. Le signal numérisé en sortie du convertisseur 601 est filtré à l'aide d'un filtre numérique 602 anti-interférence. Les bits en sortie du filtre sont recadrés sur M bits par un module de recadrage 603. Le signal numérisé et recadré est ensuite utilisé pour démoduler 606, 607, 608, 609 le ou les canaux de communications reçus.

Comme pour le premier mode de réalisation, deux boucles CAG en cascade 604, 605 sont également mises en oeuvre. La première boucle CAG 604 est une boucle CAG analogique classique se basant sur une estimation de la puissance en sortie du convertisseur CAN 601. La seconde boucle CAG 605 est une boucle CAG numérique se basant sur une estimation de la puissance en sortie du filtre anti-interférence 602 et dont l'objectif est de déterminer la consigne de commande de la première boucle.

La boucle CAG numérique 605 génère une consigne g. Cette consigne est, par exemple, adaptée par un module de saturation 610 afin d'obtenir deux consignes de commandes adaptées g1 et g2.

La consigne de commande adaptée g1 est déterminée par le module de saturation 610 de la même manière que dans le premier mode de réalisation. g1 est ensuite convertie 612 en une consigne G1 = e^{g1} utilisée comme consigne de commande de la boucle CAG analogique 604.

Si les traitements qui suivent le filtre numérique ne requièrent pas beaucoup de bits par échantillon de signal, il est avantageux de réduire le nombre de bits M < N au strict nécessaire afin de simplifier les calculs et donc de réduire le volume, le coût et la consommation du ou des composants du récepteur. La boucle CAG numérique 605 est alors utilisée pour adapter 613 la puissance du signal après filtrage anti-interférence dans la fenêtre de codage du recadrage.

De manière à tenir compte de la saturation de la consigne de g1, une consigne adaptée g2 est déterminée par le module de saturation 610 à partir de la consigne g. Cette consigne adaptée est convertie 611 en un gain G2 = e^{g2}, le gain G2 étant ensuite appliqué 613 au signal en sortie du filtre anti-interférence.

La figure 7 présente la manière dont les consignes de commandes g1 et g2 utilisées dans le second mode de réalisation peuvent être déterminées. La consigne de commande g1 est déterminée comme précédemment décrit à l'aide de la figure 5. La consigne de commande g2 est déterminée à partir de g et g1 de manière à ce que l'expression suivante soit vérifiée :
g2 = g - g1

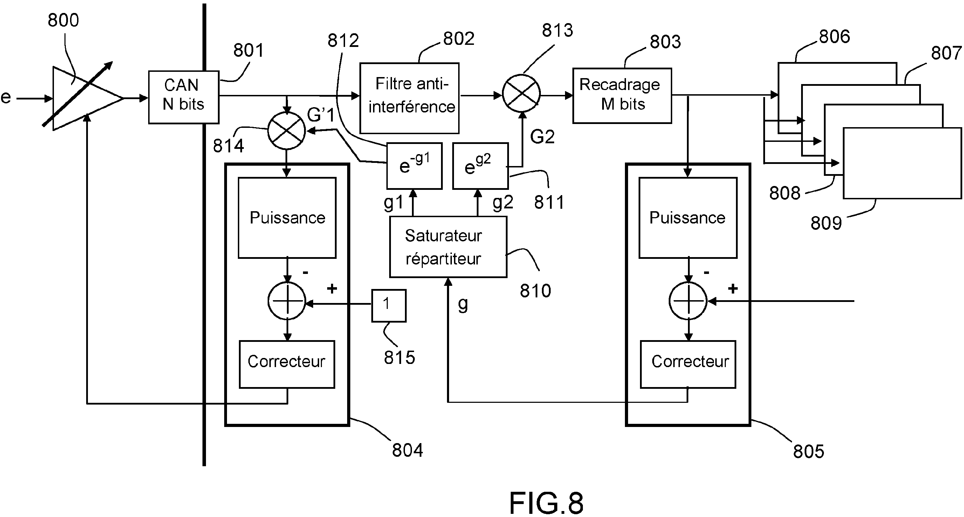

La figure 8 présente un troisième mode de réalisation du système de conversion analogique-numérique selon l'invention. Le système est composé d'une chaîne de transmission comprenant un étage analogique lui même composé d'un amplificateur à gain variable 800. Cet amplificateur a pour objectif l'amplification d'un signal analogique e d'entrée. Après amplification, le signal est traité par un convertisseur CAN 801 sur N bits. Le signal numérisé en sortie du convertisseur 801 est filtré à l'aide d'un filtre numérique anti-interférence 802. Les bits en sortie du filtre sont recadrés 803 sur M bits. Le signal numérisé et recadré est ensuite utilisé pour démoduler 806, 807, 808, 809 le ou les canaux de communications reçus.

Comme pour les deux premiers modes de réalisation, deux boucles CAG en cascade 804, 805 sont mises en oeuvre. La première boucle CAG 804 est une boucle CAG analogique classique se basant sur la sortie du convertisseur CAN 801. La seconde boucle CAG 805 est une boucle CAG numérique se basant sur la sortie du filtre anti-interférence 802. Un module de saturation 810 déduit de la consigne de commande g de la boucle CAG numérique deux consignes de commandes adaptées g1 et g2 comme précédemment décrit à l'aide de la figure 7. Un gain G2 est déterminé 812 à partir de la consigne adaptée g2 de la même manière que pour le second mode de réalisation. Le gain G2 est appliqué 813 au signal en sortie du filtre numérique anti-interférence 802. A la différence du second mode de réalisation, un gain G1' est déterminé à partir de g1 de manière à ce que G1' = exp(-g1) ou la fonction exp() représente la fonction exponentielle. Le gain numérique G1' est appliqué 814 en amont du calcul de puissance de la boucle CAG analogique 804. Cela a pour effet de faciliter la réalisation de la boucle CAG analogique 804 en limitant le nombre de bits requis pour les calculs. Ce mode de réalisation permet de retrouver une constante de temps invariante grâce à une consigne constante 815.

Ainsi, il apparaît que dans le cadre de l'invention, la boucle CAG analogique peut être contrôlée de deux manières. La première manière est d'adapter la consigne utilisée pour la comparaison mise en oeuvre par la boucle CAG analogique et la deuxième manière est d'appliquer un gain au signal en sortie du convertisseur CAN avant estimation de puissance par la boucle CAG analogique.

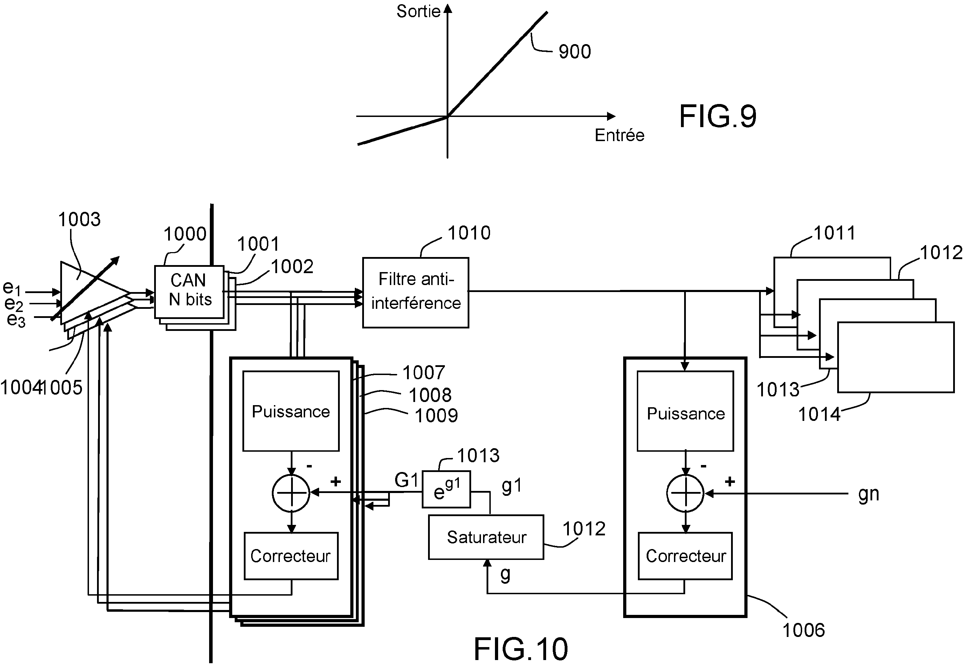

En présence dans la bande utile du signal d'interférences pulsées en grand nombre, l'estimation de la puissance après le filtre anti-interférence peut être biaisée. Il peut en résulter une valeur de consigne g insuffisante. Cette valeur trop faible de g peut alors entraîner la perte du signal utile, et ce à cause d'un recadrage trop haut. D'autre part, si on applique la technique de excision de pulse désignée par le mot anglais « blanking » après le filtre anti-interférence, le seuil de mise à zéro peut être trop haut et laisser passer trop d'interférences dans les canaux de traitement du signal. Pour mémoire, la technique dite de « blanking » consiste à mettre à zéro le signal lorsqu'une puissance trop importante est détectée, cette puissance traduisant la présence d'interférence pulsée. Afin de limiter ces inconvénients, une solution consiste à introduire une non linéarité avant le correcteur des deux boucles CAG en utilisant des modules de non-linéarité, et ce afin de donner plus de poids au signal au moment où celui-ci n'est pas perturbé, c'est-à-dire lorsque la puissance estimée est plus faible. La figure 9 donne un exemple de non-linéarité pouvant être avantageusement mise en oeuvre par un module de non-linéarité. La courbe 900 illustre la relation entre le signal d'entrée du module et le signal en sortie du module.

La figure 10 présente un quatrième mode de réalisation de l'invention dans une architecture multi-capteurs. En effet, le système selon l'invention peut être mis en oeuvre au sein d'un récepteur multi-capteurs, c'est-à-dire recevant plusieurs signaux analogiques e1, e2, e3 sur plusieurs antennes.

Dans cet exemple, une architecture à trois capteurs est prise en compte. Le système est composé d'une chaîne de transmission comprenant un étage analogique composé d'un amplificateur à gain variable 1003, 1004, 1005, un amplificateur étant alloué à un capteur. Ces amplificateurs ont pour objectifs l'amplification des signaux analogiques e1, e2, e3 d'entrées. Après amplification, les signaux sont traités par des convertisseurs CAN 1000, 1001, 1002 fonctionnant sur N bits. Les signaux numérisés sont traités par un procédé de traitement anti-interférence 1010. Le signal numérique résultant de ce traitement, par exemple un somme pondérée des signaux d'antennes, est ensuite utilisé pour démoduler 1011, 1012, 1013, 1014 le ou les canaux de communications reçus. Dans ce mode de réalisation, une unique boucle CAG numérique est utilisée, ladite boucle se basant sur une estimation de la puissance moyenne du signal en sortie d'une somme pondérée des signaux d'antenne. Pour chaque capteur ou antenne, une boucle CAG analogique 1007, 1008, 1009 associée à chaque convertisseur CAN 1000, 1001, 1002 est utilisée. Une même consigne de commande G1 résultant 1013 d'une consigne g1 adaptée par un module de saturation 1012 à partir de la consigne de commande g de la boucle CAG numérique 1006 sert de consigne de commande pour les boucles CAG analogiques 1007, 1008, 1009.

Une remarque générale concerne les blocs de conversion 425, 611, 612, 811, 812, 1013 qui ont pour objectifs de convertir des valeurs exprimées en dB en valeurs linéaires afin que les consignes puissent être exploitées par les comparateurs ou utilisées comme gains 613, 813, 814. La consigne g en sortie de la CAG numérique est exprimée en dB, c'est-à-dire en échelle logarithmique, de façon à conserver une constante de temps indépendante de la puissance reçue. De la même façon, la commande de gain analogique ga en sortie de la CAG analogique est exprimée en échelle logarithmique, l'amplificateur à gain variable attendant une commande en dB.

Avantageusement, les différents modes de réalisation du système de conversion analogique-numérique selon l'invention restent robustes à tous les types d'interférences, bande étroite ou large, pulsée ou continue. Il est particulièrement efficace pour les interférences pulsées à bande étroites par rapport à un système comprenant une simple boucle CAG à codage haut en permettant un filtrage numérique efficace sans saturation ni augmentation du bruit de quantification. Ainsi, l'invention peut être mise en oeuvre avantageusement quelque soit le traitement numérique anti-interférence utilisé. Ce traitement peut être par exemple un filtrage numérique de type FIR, un traitement d'amplitude ADP, acronyme venant de l'expression anglo-saxonne « Amplitude Data Processing », un traitement spatial utilisant une antenne multi-capteurs ou un traitement spatio-temporel STAP, acronyme venant de l'expression anglo-saxonne « Space Time Adaptative Processing ». Ainsi, le fait que les modes de réalisation des figures 4, 6 et 8 mettent en oeuvre des traitements de type filtres numériques anti-interférence ne doit pas être considéré comme une limitation de la portée de l'invention.

## Revendications

1. Système de conversion analogique-numérique comprenant au moins un amplificateur à gain variable (400, 600) amplifiant un signal d'entrée e, un convertisseur analogique-numérique CAN (401, 601) numérisant ledit signal e, un module de traitement numérique anti-interférence (407, 602) du signal numérisé, une première boucle de contrôle automatique de gain CAG (402, 604) dite boucle CAG analogique comparant une estimation (403) de la puissance en sortie du convertisseur CAN (401, 601) avec une consigne de commande g1 appelée consigne de commande de la boucle CAG analogique, un gain ga utilisé pour contrôler l'amplificateur à gain variable (400, 600) étant déduit de cette comparaison, **caractérisé en ce qu'**il comprend en outre une seconde boucle de contrôle automatique de gain CAG (420, 605) dite boucle numérique, ladite boucle numérique comparant (423) une estimation (421) de la puissance après le traitement numérique anti-interférence (407, 602) avec une consigne de commande gn prédéterminée, la boucle CAG analogique (402, 604) étant contrôlée par une consigne de commande (402, 604, 804) déduite de cette comparaison.

2. Système de conversion analogique-numérique selon l'une quelconque des revendications précédentes dans lequel les estimations de puissance (403, 421) utilisées par les boucles CAG analogique et numériques sont des estimations de puissance moyenne.

3. Système de conversion analogique-numérique selon l'une quelconque des revendications précédentes dans lequel la consigne commande de la boucle CAG analogique (402) est déterminée par la boucle CAG numérique en utilisant un correcteur (405), ledit correcteur (405) appliquant un gain au résultat de la comparaison (423) et intégrant les échantillons de signal ainsi obtenus et dans lequel le gain ga est déterminé par la boucle CAG analogique en utilisant un correcteur (422), ledit correcteur (422) appliquant un gain au résultat de la comparaison (404) et intégrant les échantillons de signal ainsi obtenus.

4. Système de conversion analogique-numérique selon la revendication 3 dans lequel une constante de temps différente est utilisée pour les deux boucles CAG, la constante de temps de la boucle CAG analogique (402) étant choisie de durée inférieure à la constante de temps de la boucle CAG numérique (420).

5. Système de conversion analogique-numérique selon l'une quelconque des revendications précédentes dans lequel un correcteur (422) détermine une consigne g, un module de saturation (424) adaptant cette consigne de manière à obtenir la consigne de commande de la boucle CAG analogique g1 adaptée de sorte que :
| | | |
|---|---|---|
| si g ≥ gmax | alors | g1 = g1 max |
| si g1 min < g < g1 max, | alors | g1 = g |
| si g ≤ g1 min | alors | g1 = g1min |
expressions dans lesquelles :
g1min correspond à la marge de quantification du convertisseur CAN (401);
g1 max correspond à la marge de saturation du convertisseur CAN (401).

6. Système de conversion analogique-numérique selon la revendication 5 dans lequel le module de saturation (610) détermine une seconde consigne adaptée g2 à partir de la consigne g de manière à ce que g2 = g - g1, le gain g2 étant appliqué (613) au signal en sortie du traitement numérique anti-interférence (602).

7. Système de conversion analogique-numérique selon l'une quelconque des revendications précédentes dans lequel un module d'excision de pulse est mis en oeuvre après le traitement numérique anti-interférence (407, 602).

8. Système de conversion analogique-numérique selon la revendication 7 dans lequel un module de non-linéarité est mis en oeuvre dans la boucle CAG analogique après comparaison (404), ce module ayant pour fonction de donner plus de poids au signal au moment où celui-ci n'est pas perturbé, c'est-à-dire lorsque la puissance estimée est plus faible.

9. Système de conversion analogique-numérique selon l'une quelconque des revendications 7 ou 8 dans lequel un module de non-linéarité est mis en oeuvre dans la boucle CAG numérique après comparaison (423), ce module ayant pour fonction de donner plus de poids au signal au moment où celui-ci n'est pas perturbé, c'est-à-dire lorsque la puissance estimée est plus faible.

10. Système de conversion analogique-numérique selon l'une quelconque des revendications précédentes dans lequel plusieurs signaux analogiques d'entrée e1, e2, e3 en provenance de plusieurs capteurs sont amplifiés et convertis en signaux numériques, un amplificateur à gain variable (1003, 1004, 1005) et un convertisseur CAN (1000, 1001, 1002) étant associé à un signal d'entrée, ces signaux d'entrée après avoir été amplifiés et numérisés étant traités par un module de traitement numérique anti-interférence (1010) de sorte qu'un signal résultant d'une combinaison des signaux numérisés soit obtenu, une boucle CAG numérique étant utilisée pour déterminer une consigne de commande G1 utilisée par une pluralité de boucles CAG analogiques, une boucle CAG analogique (1007, 1008, 1009) étant utilisée par signal d'entrée.

11. Système de conversion analogique-numérique selon l'une quelconque des revendications précédentes dans lequel le traitement numérique anti-interférence est un filtre numérique à réponse impulsionnelle finie.

12. Système de conversion analogique-numérique selon l'une quelconque des revendications 1 à 10 dans lequel le traitement numérique anti-interférence est un traitement d'amplitude ADP.

13. Système de conversion analogique-numérique selon l'une quelconque des revendications 1 à 10 dans lequel le traitement numérique anti-interférence est un traitement spatial utilisant une antenne multi-capteurs ou un traitement spatio-temporel STAP.

14. Système de conversion analogique-numérique selon l'une quelconque des revendications précédentes dans lequel un module de recadrage (603) est mis en oeuvre après le traitement numérique anti-interférences.

15. Système de conversion analogique-numérique selon l'une quelconque des revendications précédentes dans lequel le signal d'entrée est un signal large bande généré en utilisant la technique d'étalement de spectre.

16. Système de conversion analogique-numérique comprenant au moins un amplificateur à gain variable (800) amplifiant un signal d'entrée e, un convertisseur analogique-numérique CAN (801) numérisant ledit signal e, un module de traitement numérique anti-interférence (802) du signal numérisé, une première boucle de contrôle automatique de gain CAG (804) dite boucle CAG analogique comparant une estimation (403) de la puissance en sortie du convertisseur CAN (801) avec une consigne de commande g1 appelée consigne de commande de la boucle CAG analogique, un gain ga utilisé pour contrôler l'amplificateur à gain variable (800) étant déduit de cette comparaison, **caractérisé en ce qu'**il comprend en outre une seconde boucle de contrôle automatique de gain CAG (805) dite boucle numérique, ladite boucle numérique comparant (423) une estimation (421) de la puissance après le traitement numérique anti-interférence (802) avec une consigne de commande gn prédéterminée, la boucle CAG analogique (804) étant contrôlée en appliquant un gain au signal en sortie du convertisseur CAN (801) avant estimation (421) de la puissance du signal, ce gain étant déterminé en utilisant ladite comparaison.
